**Europäisches Patentamt**

**European Patent Office**

**Office européen des brevets**

(19)

(11) Veröffentlichungsnummer: **0 281 520 B1**

(12)

# EUROPÄISCHE PATENTSCHRIFT

(45) Veröffentlichungstag der Patentschrift:
27.12.91 Patentblatt 91/52

(51) Int. Cl.$^5$: **B05C 5/00**, G03F 7/16

(21) Anmeldenummer: 88810119.3

(22) Anmeldetag: 26.02.88

(54) **Trennorgan zum Beschneiden der Breite eines Giessvorhanges.**

(30) Priorität: 03.03.87 CH 792/87

(43) Veröffentlichungstag der Anmeldung:
07.09.88 Patentblatt 88/36

(45) Bekanntmachung des Hinweises auf die
Patenterteilung:
27.12.91 Patentblatt 91/52

(84) Benannte Vertragsstaaten:
AT BE CH DE FR GB IT LI NL SE

(56) Entgegenhaltungen:
EP-A- 0 002 040
EP-A- 0 145 648
FR-A- 2 580 199
US-A- 4 060 649

(73) Patentinhaber: CIBA-GEIGY AG
Klybeckstrasse 141
CH-4002 Basel (CH)

(72) Erfinder: Denz, Martin
Waldenburgerstrasse 10
CH-4052 Basel (CH)
Erfinder: Kapp-Schwoerer, Diethard
Markgräflerstrasse 9
CH-4057 Basel (CH)

## Beschreibung

Die Erfindung betrifft ein zum Beschneiden der Breite eines Gießvorhanges in einer Beschichtungsvorrichtung dienendes Trennorgan der im Oberbegriff des Patentanspruchs 1 beschriebenen Art.

Solche Trennorgane neuerer Art sind z.B. in der EP-A-0145648 (= USA-4559896) offenbart. Die darin beschriebenen Trennorgane einer Beschichtungsvorrichtung an sich bekannter Art, von welchen üblicherweise das eine zum Beschneiden des in Bewegungsrichtung linken und das andere zum Beschneiden des rechten Randbereiches des Gießvorhanges aus Beschichtungsmaterial dient, umfassen ein jedes neben einem oberen, in den Gießvorhang hineinragenden, die Vorhangbreite beschneidenden und das Beschichtungsmaterial des abgeschnittenen Randbereichs seitlich wegführenden Trennelement mit nach unten anschließender Kantenführung noch ein zweites, unterhalb des ersten seitlich etwas einwärts gestaffeltes Trennelement, welches die Breite des Gießvorhanges durch Beschneiden eines eventuellen sich auch dann noch bildenden Zwischenrandwulstes nochmals verringert. Dabei kann die seitliche Vorhangrandführung einen nach unten einwärts, d.h. zur Vorhangmitte hingeneigten unteren Abschnitt, der eine Breitenverringerung des Vorhangmittelbereichs bewirkt, oder auch einen nach unten auswärts gerichteten Abschnitt aufweisen, der nach abwärts eine leichte Verbreiterung oder "Spreizung" des Vorhanges mit entsprechender Reduktion der Vorhangdicke bewirkt. Auch kann die seitliche Führung des Randbereichs des beschnittenen Vorhangmittelbereichs einen oberen, nach unten auswärts gerichteten und an diesen nach unten anschließend, einen etwas einwärts geneigten Abschnitt besitzen.

Der auswärts geneigte Abschnitt kann bei diesem bekannten Trennelement mit der Lotrechten einen Winkel β von vorzugsweise bis zu 5° bilden, während ein an diesen Abschnitt nach unten einwärts gerichteter Abschnitt mit der Lotrechten vorzugsweise einen Winkel von 1° bis 8° bildet, der zeichnerisch größer dargestellt ist, als der Winkel β.

Bekanntlich ist die Dicke des Gießvorhanges nicht über die gesamte Breite konstant, sondern es bildet sich an den stets erforderlichen seitlichen Vorhangrandführungen unvermeidlich ein ausgeprägter Randwulst aus, der sich je nach den rheologischen Eigenschaften des Beschichtungsmaterials mehr oder weniger weit in den mittleren Vorhangbereich erstreckt. Die Breite dieses verdickten Randbereichs beträgt an jedem der beiden Längsränder des Vorhangs bzw. der aus diesem auf einem zu beschichtenden Objekt gebildeten Auflage etwa 5 bis 20 mm ; die Höhe des Randwulstes über der Auflageschicht kann dabei 1 bis 2 mm betragen. Bei der Anfertigung von elektronischen Leiterplatten, z.B. für Elektronikgeräte mit zahlreichen äußerst feinen Leitungsfäden, bei denen ein Randbereich der Platte unbeschichtet bleiben soll, ist die Ausbildung solcher Wülste, z.B. bei der Beschichtung als Lötstoppmasken höchst störend oder sogar völlig unzulässig, und kann zu Schwierigkeiten bei der weiteren Verarbeitung der beschichteten Platten führen.

Mit den untereinander gestaffelt angeordneten beiden Trennelementen jedes Trennorgans der bekannten Beschichtungsvorrichtung wurde nun die Bildung der unerwünschten Randwülste, wie im nachhinein gefunden wurde, doch in vielen Fällen nicht in zufriedenstellendem Maße unterdrückt.

Denn infolge der rasch voranschreitenden Entwicklung auf dem Gebiet der Leiterplattentechnologie genügt heute nicht mehr ein Freilassen der beiden gegenüberliegenden Längsränder beim Auftreffen des Gießvorhanges auf die unter ihm mit annähernd gleicher Geschwindigkeit vorbeibewegte, zu beschichtende Leiterplatte, sondern heute soll die zum Aufbringen einer Lötmaske dienende Beschichtung oft nur in bestimmten ausgewählten Feldern auf der Leiterplatte erfolgen. Hier wirken sich nun Randwülste im Leitergebiet besonders ungünstig aus.

Es wurde nun festgestellt, daß mit der Beschichtungsvorrichtung nach der EP-A-0145648 immer noch Randwülste entstanden, die sich bei einer applizierten Schichtdicke nach der Trocknung von ca. 30 mcm über ein Randgebiet von etwa 10 bis 20 mm erstrecken konnten, was also eine Verringerung der verwendbaren Leiterplattenbreite von immerhin 20 bis 40 mm (beide Randzonen zusammen) bedeutet, nicht gerechnet Verluste an Leiterfeldern, die im Innenbereich der Leiterplatte auftreten, falls nur Teilgebiete des Leiterfeldes mit Lötmasken versehen werden sollen. Die Randwülste traten öfter als Doppelwülste auf, von denen die äussere Wulst eine Höhe von bis zu 110 micrometer (mcm) und die innere eine solche von bis zu 70 mcm erreichen kann, wenn für die Beschichtung hierfür bei der Erzeugung von Lötmasken bevorzugte, in der US-A-4230793 (EP-A-0002040) in Spalte 3, Zeile 62 bis Spalte 4, Zeile 7 beschriebene Verfahren und die dort beschriebene Lösung verwendet wurden, und wenn dabei ein Giessvorhang von etwa 40 mcm Dicke mit einer Geschwindigkeit von 90 m/min. auf einer mit etwa gleicher Geschwindigkeit vorbeibewegten Leiterplatte einen Naßgewichtauftrag von etwa 7.5 g je 600 cm² Leiterfläche erzeugt. Die Dicke der aufgetragenen Trockenschicht beträgt im allgemeinen unter den genannten Bedingungen und unter Verwendung der genannten Lösung als Beschichtungsmaterial etwa 25 bis 35, vorzugsweise etwa 28 bis 30 mcm.

Zum entfernteren Stand der Technik gehören noch die FR-A-2580199, welche sich mit der Verbreiterung von Giess vorhängen beschäftigt, sowie die US-A-4060649, die spezielle Kantenführungen für Giessvorhänge beschreibt. Beide Druckschriften können offensichtlich nichts zur Lösung der nachstehend definierten, der Erfindung zugrunde liegenden Problemstellung beitragen.

Es ist Aufgabe der vorliegenden Erfindung, ein Trennorgan der eingangs beschriebenen Art zu verwirklichen, das die verhältnismäßig aufwendige Konstruktion der beiden Trennelemente jedes in einer Beschichtungsvorrichtung verwendeten Trennorgans wesentlich vereinfacht und dabei gleichwohl gestattet, wesentlich schmälere und niedrigere Randwülste zu erzeugen, als dies bei der vorbekannten Einrichtung der Fall ist. Es ist ein weiteres Ziel der Erfindung, eine rein laminare Strömung des Beschichtungsmaterials auch im verbreiterten Bereich E des Mittelteils des Gießvorhanges sicherzustellen und so ebenfalls Randwülste schmäler und niedriger zu halten, als dies mit den bekannten Trennorganen möglich war.

Diese Aufgabe wird gelöst und das genannte sowie weiter unten beschriebene Ziele werden nach der Erfindung durch ein Trennorgan der eingangs beschriebenen Art erreicht, welches die im kennzeichnenden Teil des Patentanspruchs 1 beschriebenen Merkmale aufweist.

Besonders erfolgreich werden die entstehenden Randwülste der beschichteten Zonen eines Objekts in Breite und Höhe bei der Verwendung von Trennorganen nach der Erfindung verringert, welche zumindest eines, besser aber noch mehrere der in den Unteransprüchen 2 bis 7 beschriebenen Merkmale besitzen.

Das Trennorgan nach der Erfindung wird nun an Hand von in der beigefügten Zeichnung dargestellten Ausführungsbeispielen näher erläutert ; in der Zeichnung ist

Fig. 1 eine schematische Seitenansicht einer ersten Ausführungsform des Trennorgans nach der Erfindung, teilweise im Längsschnitt,

Fig. 2 eine ähnliche Darstellung einer zweiten Ausführungsform und

Fig. 3 eine stärker vergrößerte Seitenansicht des Bereiches der Abtrennkante am oberen Ende des Trennorgans nach der Erfindung mit den Materialfluß andeutenden Strömungslinien.

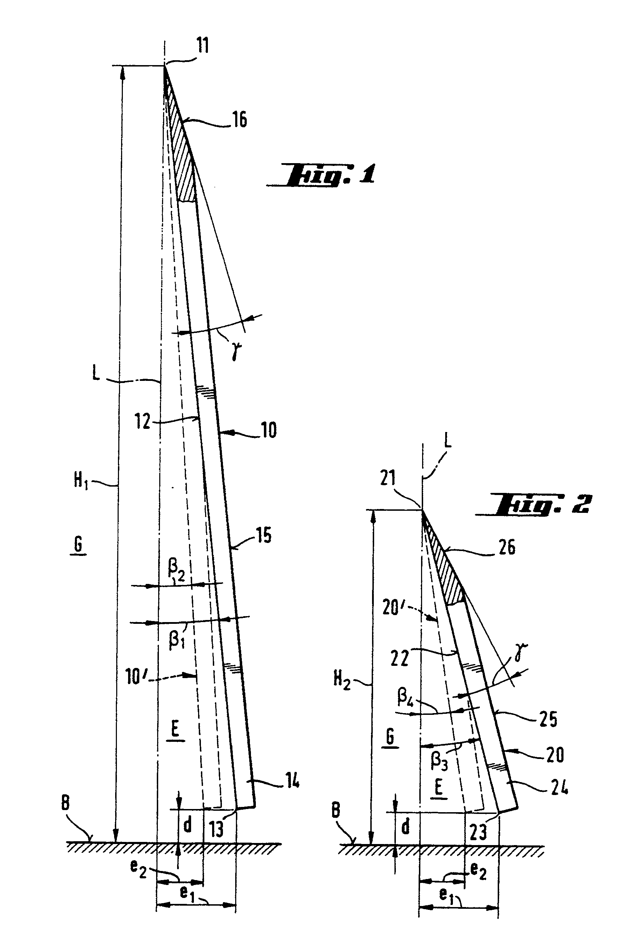

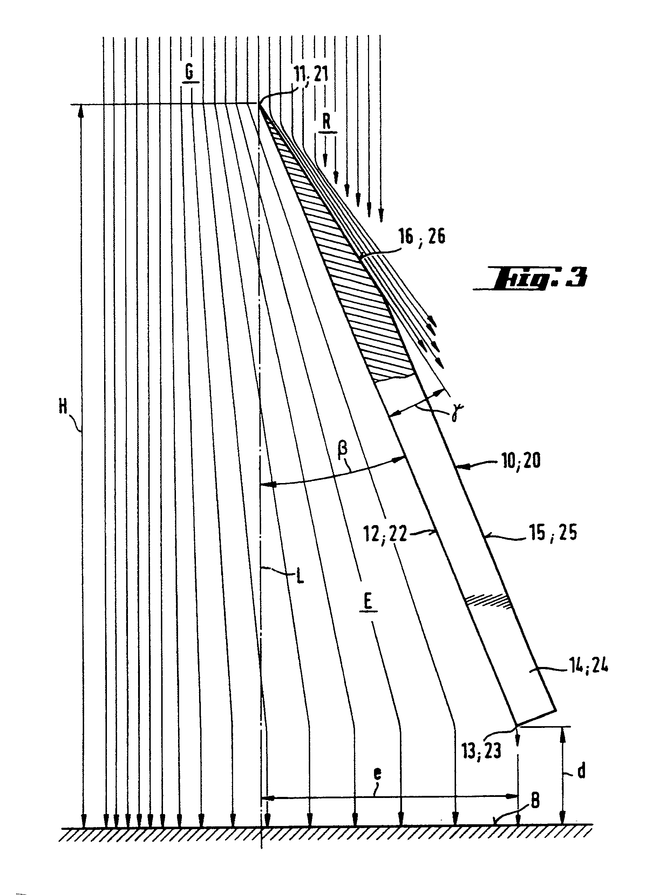

Die in Fig. 1 gezeigte, gegenuber einer praktischen Durchführungsform mehrfach vergrößerte Darstellung des Trennorgans 10 nach der Erfindung weist an ihrem oberen Ende 11 eine messerscharfe Abtrennkante 11 auf, deren Höhe $H_1$-O lotrecht über der Beschichtungsebene B in einem praktischen Ausführungsbeispiel 70 mm betragen soll ; dieses Ausführungsbeispiel wie auch dasjenige in Fig. 2 ist also in mehrfacher Vergrößerung dargestellt.

Auf seiner der Gießvorhangmitte zugekehrten Seite besitzt das Trennorgan 10 eine einzige durchgehend glatte ebene Wandfläche 12, die sich von der Abtrennkante 11 bis zu einer unteren Endkante 13 am Fußende 14 des Trennorgans 10 erstreckt. Die Endkante 13 befindet sich im Abstand von etwa 3 bis 4 mm über der Beschichtungsebene B. Die Abtrennkante 11 kommt dadurch zustande, daß auf der von der Gießvorhangmitte abgewandten Rückseite 15 an deren oberem Ende eine die Kante 11 zuspitzende Schrägfläche 16 vorgesehen ist, die z.B. angeschliffen wird. Das Trennorgan wird daher vorzugsweise aus einem Chromnickelstahl, z.B. $V_2A$-Stahl angefertigt.

Die gewünschte Verringerung der Randwulstbreite und -höhe wird nun durch eine seitliche Erweiterung E des Mittelbereichs des Gießvorhanges G erzielt, die etwa 3 bis 9, vorzugsweise aber 4 bis 7 mm in der sich durch die Endkante 13 parallel zur Beschichtungsfläche B erstreckenden Ebene betragen soll. In der in Fig. 1 mit ausgezogenen Linien gezeigten Stellung des Trennorgans 10 beträgt der Abstand der unteren Endkante 13 von der Lotrechten L in der letztgenannten Ebene 7 mm. Hierzu muß die glatte Wandfläche 12 des Trennorgans 10 mit der Lotrechten L an der Abtrennkante 11 einen Winkel $\beta$ von 5.5° einschließen. Genügt für das Erreichen des genannten Zweckes bereits eine Erweiterung E von 4 mm, was von den rheologischen Eigenschaften des den Vorhang bildenden Beschichtungsmaterials abhängt, so kann der genannte Winkel $\beta$ 3.5° betragen. Unbedingte Voraussetzung hierzu ist, wie bereits erwähnt, eine möglichst scharfe Ausbildung der Abtrennkante 11 und eine völlig glatte, von jeder Unebenheit, die örtliche Turbulenzen im an der Wandfläche 12 entlang strömenden, sich erweiternden Bereich E des Gießvorhangs G erzeugen könnte, freie Wandfläche 12. In der erwähnten Stellung, in der der Winkel zwischen der Lotrechten L und der Wandfläche 12 nur 3,5° beträgt, ist das Trennorgan 10' in Fig. 1 gestrichelt gezeigt.

Das gleiche Ergebnis einer erwünschten Verbreiterung des seitlichen Gießvorhangbereichs E um 3 bis 8 mm kann nun auch mit einem wesentlichen kürzeren Trennorgan 20 von z.B. nur 28 mm Länge der Wandfläche 22 erreicht werden, wenn dieses Trennorgan z.B. unter einem Winkel von 14,5° oder unter 8,5° zur Lotrechten L geneigt wird und die Höhe $H_2$-O seiner Abtrennkante 21 über der Beschichtungsebene B nur 30 mm beträgt. In der Stellung mit der Neigung von 14,5° ist das Trennorgan 20 voll ausgezogen, in der Stellung mit der Neigung von 8,5° gestrichelt dargestellt. Der Abstand der unteren Endkante 23 von der Beschichtungsebene B beträgt wiederum 3 mm, sowohl in der Stellung 20 als auch in der Stellung 20' des Trennorgans. Der Abstand $e_1$ der unteren Endkante 23 von der Lotrechten L in der Stellung 20 beträgt 7 mm, der Abstand $e_2$ in der gestrichelten Stellung 20' nur 4 mm.

Es ist hieraus ersichtlich, daß das Trennorgan nach der Erfindung in einem weiten Bereich, z.B. von 20 bis 80 mm Länge angefertigt und so den Abmessungen angepaßt werden kann, die in bereits vorhandenen Beschichtungsvorrichtungen vorgesehen sind.

Die Einstellbarkeit der Neigung gegen die Lotrechte wird durch entsprechende bekannte Einrichtungen gewährleistet und gestattet ein Anpassen an verschiedene Beschichtungsmaterialien mit unterschiedlicher Adhäsion an das die Wandfläche 12, 22 des Trennorgans 10, 20 bildende Material, sei es ein geeignetes Metall, insbesondere ein nichtrostender Stahl, oder ein entsprechend harter Kunststoff, der die Ausbildung einer messerscharfen oberen Abtrennkante gestattet.

In Fig. 3 sind die an der Abtrennkante 11, 21 vorliegenden Strömungsverhältnisse im laminar abwärts vorbeifließenden Gießvorhangmaterial schematisch dargestellt. Das obere Ende des Trennorgans 10 nach der Erfindung mit der Abtrennkante 11 ist dabei stark vergrößert wiedergegeben. Die Neigung der einwärts, also zur Gießvorhangmitte gerichteten Wandfläche 12 gegen die Lotrechte beträgt 22°, so daß eine Verbreiterung E des Gießvorhangmittelbereichs von 8 mm bereits bei einer Höhe der Abtrennkante 11 über der Beschichtungsebene von 23 bis 24 mm erreicht wird.

Vorzugsweise ist die Länge der glatten Wandfläche 11, 21 etwas kürzer als sie es sein müßte, damit in ihrem unteren Endbereich sich der verbreiterte Gießvorhang schon etwas über der unteren Endkante 13, 23 von alleine infolge der Überwindung der Adhäsion am Trennorgan dank des Eigengewichts des Gießvorhanges ablöst.

Auf der von der Gießvorhangmitte abgewandten Rückseite 15, 25 des Trennorgans 10, 20 werden in üblicher Weise Mittel wie z.B. eine Rinne oder Rutsche oder dergl. angebracht, die das aus dem abgeschnittenen Randbereich des Gießvorhanges G stammende Material R seitlich nach auswärts wegführen. Solche Mittel sind z.B. in Fig. 3 der EP-A-0145648 dargestellt (Bezugsziffern 12 bzw. 22). Um jede Turbulenz an der Schneide der Abtrennkante 11, 21 des Trennorgans 10, 20 zu vermeiden, sollten derartige Ableitungsmittel für das abgeschnittene Randmaterial mindestens 10 mm unterhalb der Abtrennkante angebracht sein, damit nicht ein Materialstau beim Eintritt dieses Materials in die Rutsche oder Rinne sich rückwärts nach oben aufbaut und die laminare Strömung oberhalb der Abtrennkante durch Wirbelbildungen stört.

Aus dem gleichen Grunde wird auch die die Abtrennkante schärfende Schrägfläche 16, 26 auf der rückseitigen Wandung 15, 25 des Trennorgans 10, 20 nach der Erfindung angebracht, und nicht auf dessen Vorderseite 12, 22, wie dies bei den Trennorganen der Beschichtungsvorrichtung der EP-A-0145648 der Fall ist.

Mit der gleichen Beschichtungsvorrichtung, wie sie in der EP-A-0145648 beschrieben ist, in die jedoch an Stelle der dort beschriebenen Trennorgane rechts und links der Gießvorhangmitte Trennorgane nach der Erfindung mit einer Länge von 59 mm eingebaut waren, wurden nun unter den gleichen Verfahrensbedingungen und mit der gleichen Lötmasken-Vorlösung ebenso große Flächen wie oben erwähnt beschichtet und dabei nur Randwülste von 2 mm Breite und einer Höhe von 52 mcm bei gleicher Dicke der aufgetragenen Schicht von 28 bis 30 mcm erhalten. Auch trat nur die äußere und keine innere Randwulst auf. Der Verlust an Leiterfeld durch die Randwulstbildung betrug also nur ein Fünftel des bei der bekannten Vorrichtung mit doppelten Trennelementen erzeugten. Die Höhe der Abtrennkante des Trennorgans betrug dabei 65 mm über der Beschichtungsebene, und die Neigung der glatten Innenwandfläche des Trennorgans zur Lotrechten etwa 4,5 bis 6°.

Ein weiterer Vorteil der Verwendung von Trennorganen nach der Erfindung in Beschichtungsvorrichtungen bekannter Bauart beruht in einer nicht unerheblichen Einsparung an teurem Beschichtungsmaterial.

Die Dicke der Trennorgane 10, 20 ist in der Zeichnung wesentlich stärker dargestellt, als dies in der Praxis erforderlich sein muß. So genügt z.B. bei einem Trennorgan aus $V_2A$-Stahl je nach Länge eine Dicke von 0,5 bis 1 mm.

Eine nochmalige Verringerung der Breite und Höhe von bei der Beschichtung von Leiterplatten an den Rändern des mit zwei Trennorganen aus einem Gießvorhang der beschriebenen Art herausgeschnittenen Mittelbereichs oder kleineren Teilbereichs wird erzielt, wenn die glatte, einwärts gerichtete Wandfläche 12, 22 des Trennorgans mit einer dünnen Edelmetallschicht, z.B. mit Gold, Silber oder einem Platinmetall überzogen wird.

## Patentansprüche

1. Trennorgan (10, 20) zum Beschneiden der Breite eines Gießvorhanges aus Beschichtungsmaterial oberhalb dessen Auftreffstelle auf ein zu beschichtendes, quer zur Vorhangfließrichtung im Abstand unterhalb des Fußendes (14, 24) des Trennorgans vorbeibewegtes Objekt, insbesondere eine Leiterplatte, wobei das Trennorgan gegenüber der Lotrechten (L) unter einem solchen Winkel (β) schräggestellt ist, daß das obere Ende des Trennorgans gegenüber dessen Fußende in Richtung zur Vorhangmitte hin vorspringt und trennend in den Vorhangbereich hineinragt, so daß ein Randstreifen vom Mittelbereich des Vorhangs abgetrennt und das abgetrennte Beschichtungsmaterial seitlich weggeführt, der beschnittene Mittelbereich des Gießvorhanges jedoch nach unten und seitlich zum Trennorgan hin verbreitert wird, **dadurch gekennzeichnet, daß** das Trennorgan (10, 20) aus einem einzigen Element besteht, dessen oberes Ende als messerscharfe Abtrennkante (11, 21) ausgebildet ist, daß die dem Mittelbereich des Gießvorhanges (G) zugewandte Seite des Trennorgans (10, 20) eine sich von der Abtrennkante (11, 21) in Richtung zum Fußende (14, 24) des Trennorgans hin in nur einer Ebene erstreckende, geschlossene, glatte Wandfläche (12, 22) bildet, die sich bis zu einer unteren Endkante (13, 23) am Fußende (14, 24) des Trennorgans erstreckt und deren Neigung gegen die Lotrechte so eingestellt werden kann, daß der beschnittene Mittelbereich des Gießvorhanges laminar und sich seitlich verbreiternd an der Wandfläche (12, 22) abwärtsfließt und an der unteren Endkante (13, 23) abreißend noch mit fast der gleichen seitlichen Verbreiterung (E) direkt auf das zu beschichtende Objekt in einer zum Gießvorhang (G) querverlaufenden horizontalen Beschichtungsebene (B) auftrifft, wobei nur ein schmaler Randwulst von höchstens doppelter Höhe wie die aufgetragene Naßschicht entsteht.

2. Trennorgan nach Anspruch 1, dadurch gekennzeichnet, daß die untere Endkante (13, 23) etwas oberhalb derjenigen Höhe über der Beschichtungsebene (B) liegt, bei der sich das längs der glatten Wandfläche (12, 22) unter Adhäsion an letztere abwärtsfließende Beschichtungsmaterial des sich ververbreiternden Vorhangs unter Überwindung der Adhäsionskräfte von der glatten Wandfläche unter seinem eigenen Gewicht ablösen würde.

3. Trennorgan nach Anspruch 1, dadurch gekennzeichnet, daß die Neigung der glatten Wandfläche (12, 22) des Trennorgans (10, 20) gegenüber der Lotrechten (L) so eingestellt wird, daß der Abstand der unteren Endkante (13, 23) sich in einm Abstand von etwa 3 bis 8 mm von der Lotrechten in einer zur Beschichtungsebene (B) parallelen Ebene durch die Endkante (13, 23) befindet.

4. Trennorgan nach Anspruch 1, dadurch gekennzeichnet, daß die Neigung der glatten Wandfläche (12, 22) gegen die Lotrechte (L) von etwa 3 bis 25 und vorzugsweise von 5,5 bis 15° beträgt.

5. Trennorgan nach Anspruch 1 bis 4, dadurch gekennzeichnet, daß die Länge der glatten Wandfläche (12, 22) von der Abtrennkante (11, 21) bis zur unteren Endkante (13, 23) etwa 10 bis 500, vorzugsweise aber von 30 bis 70 mm beträgt.

6. Trennorgan nach Anspruch 1 bis 4, dadurch gekennzeichnet, daß die Abtrennkante (11, 21) durch eine Schrägfläche am oberen Ende der von der Gießvorhangmitte abgewandten Seite (15, 25) des Trennorgans (10, 20), die die glatte Wandfläche (12, 22) in der Abtrennkante (11, 21) unter einem spitzen Winkel schneidet, messerscharf gemacht ist.

7. Trennorgan nach Anspruch 1 bis 4, dadurch gekennzeichnet, daß die glatte Wandfläche (12, 22) mit einem Edelmetall beschichtet ist.

**Claims**

1. A severing organ (10, 20) for trimming the width of a poured curtain of coating material above the point of impingement thereof on an object to be coated, in particular a printed circuit board, which is moved past transversely to the direction of flow of the curtain, at a distance below the foot end (14, 24) of the severing organ, said severing organ being inclined with respect to the perpendicular (L) at such an angle (β) that the upper end of said separating organ protrudes towards the centre of said curtain with respect to the foot end thereof and projects in severing manner into the region of said curtain so that a marginal strip is severed from the central region of said curtain and the severed coating material is diverted laterally, but the cut central region of the poured curtain is downwardly and laterally spread towards said severing organ, characterised in that the severing organ (10, 20) consists of a single element, the upper end of which is designed as a knife-like, sharp severing edge (11, 21), that the side of the severing element (10, 20) close to said central region of the poured curtain (G) forms a closed, smooth wall surface (12, 22) extending in only one plane from said severing edge (11, 21) towards the foot end (14, 24) of the severing organ, which wall surface extends as far as a lower end edge (13, 23) on the foot end (14, 24) of the severing organ and the inclination of which with respect to the perpendicular can be adjusted in a manner such that the trimmed central region of the poured curtain moves downward with laminar flow and with lateral spreading along said wall surface (12, 22) and is detached at said lower end edge (13, 23) and impinges directly on the object to be coated with almost the same lateral spreading (E) in a horizontal coating plane (B) running transversely to the poured curtain (G), with only a narrow marginal bead at most twice as high as the wet layer applied being produced.

2. A severing organ according to Claim 1, characterised in that the lower end edge (13, 23) is located somewhat above the height above the coating plane (B) at which the coating material of the spreading curtain flowing down along the smooth wall surface (12, 22), adhering to the latter, would become detached from said smooth wall surface under its inherent weight, overcoming the adhesive forces.

3. A severing organ according to Claim 1, characterised in that the inclination of said smooth wall surface (12, 22) of said separating element (10, 20) relative to the perpendicular (L) is adjusted in a manner such that the lower end edge (13, 23) thereof is at a distance of about 3 to 8 mm from the perpendicular, in a plane through said end edge (13, 23) parallel to said coating plane (B).

4. A severing organ according to Claim 1, characterised in that the inclination of said smooth wall surface (12, 22) relative to the perpendicular (L) is from about 3° to 25°, and preferably from 5.5° to 15°.

5. A severing organ according to Claims 1 to 4, characterised in that the length of said smooth wall surface (12, 22) from said severing edge (11, 21) to said lower end edge (13, 23) is about 10 to 500 mm, but preferably from 30 to 70 mm.

6. A severing organ according to Claims 1 to 4, characterised in that said severing edge (11, 21) is rendered knife-like sharp by an oblique face at the upper end of the side (15, 25) of the severing organ (10, 20) remote from the centre of the poured curtain, which face intersects the smooth wall surface (12, 22) in the severing edge (11, 21) at an acute angle.

7. A severing organ according to Claims 1 to 4, characterised in that said smooth wall surface (12, 22) is coated with a noble metal.

## Revendications

1. Elément (10, 20) de séparation pour délimiter la largeur d'un rideau de coulée composé d'une matière d'enduction, au-dessus du point de rencontre de ce rideau avec un objet à enduire, notamment une plaque conductrice, qui se déplace perpendiculairement au sens d'écoulement du rideau et à une certaine distance de l'extrémité du pied (14, 24) de cet élément de séparation, ce dernier étant disposé obliquement en formant avec la verticale (L) un angle (β) tel que l'extrémité supérieure de l'élément de séparation dépasse son pied dans le sens de l'axe du rideau et pénètre dans ce rideau en le découpant, de manière à en séparer une bande latérale de la partie centrale et de manière que la matière d'enduction séparée soit écartée latéralement, la partie centrale délimitée du rideau étant cependant élargie de haut en bas et latéralement par rapport à cet élément de séparation, caractérisé en ce que cet élément (10, 20) de séparation est un élément monobloc dont l'extrémité supérieure a la configuration d'une arête tranchante (11, 21) ; le côté de cet élément (10, 20) tourné vers la partie centrale du rideau (G) forme une paroi (12, 22) à surface fermée lisse, qui part de l'arête (11, 21) de séparation vers le pied (14, 24) de l'élément dans un seul et même plan et qui va jusqu'au bord inférieur (13, 23) de ce pied (14, 24) et dont l'inclinaison, par rapport à la verticale, peut être réglée de façon que la partie centrale délimitée du rideau ait un écoulement laminaire et coule en s'étalant latéralement le long de cette paroi (12, 22) et que, sur le bord inférieur (13, 23), elle s'en détache et tombe directement, en conservant encore presque le même écartement latéral (E), sur l'objet à enduire, dans un plan (B) d'enduction, horizontal et perpendiculaire au rideau (G), en ne formant qu'un petit bourrelet marginal ayant au plus le double de l'épaisseur de la couche humide déposée.

2. Elément de séparation selon la revendication 1, caractérisé en ce que le bord inférieur (13, 23) se trouve un peu plus haut, par rapport au plan (B) d'enduction, que le point où la matière du rideau, qui s'élargit en coulant le long de la paroi lisse (12, 22) en y adhérant, se détache de cette paroi (12, 22) parce que le poids propre de la matière devient supérieur à la force d'adhésion.

3. Elément de séparation selon la revendication 1, caractérisé en ce que l'inclinaison de la paroi lisse (12, 22) de cet élément (10, 20) par rapport à la verticale (L) est réglée de façon que le bord inférieur (13, 23) se trouve à une distance d'environ 3 à 8 mm de cette verticale, dans un plan parallèle au plan (B) d'enduction et passant par ce bord (13, 23).

4. Elément de séparation selon la revendication 1, caractérisé en ce que l'inclinaison de la paroi lisse (12, 22) sur la verticale (L) est d'environ 3° à 25° et avantageusement de 5,5° à 15°.

5. Elément de séparation selon les revendications 1 à 4, caractérisé en ce que la longueur de la paroi lisse (12, 22), de l'arête (11, 21) de séparation au bord inférieur (13, 23), est comprise entre environ 10 et 500 mm, avantageusement entre 30 et 70 mm.

6. Elément de séparation selon les revendications 1 à 4, caractérisé en ce que l'arête (11, 21) de séparation est rendue tranchante par une surface oblique de l'extrémité supérieure du côté (15, 25) de l'élément (10, 20) qui est éloigné de la partie centrale du rideau de coulée et qui coupe la paroi lisse (12, 22) sur cette arête (11, 21), sous un angle aigu.

7. Elément de séparation selon les revendications 1 à 4, caractérisé en ce que la paroi lisse (12, 22) est revêtue d'un métal précieux.

EP 0 281 520 B1

Fig. 1

Fig. 2

7

Fig. 3